# EUROPEAN PATENT APPLICATION

(11) **EP 4 687 142 A1**
(43) Date of publication of application: **04.02.2026**
(21) Application number: 25191179.8
(22) Date of filing: 23.07.2025
(51) Int. Cl.: G11C 8/08, G11C 8/14, G11C 11/401, G11C 11/408

(54) **SELECTABLE WORDLINE DRIVER**

(30) Priority: 31.07.2024 US 202463677976 P; 23.06.2025 US 202519246417
(71) Applicant: MICRON TECHNOLOGY, INC., Boise ID 83707 (US)
(72) Inventor: Karda, Kamal M., BOISE ID, 83707 (US); Carman, Eric S., BOISE ID, 83707 (US)
(74) Representative: Pio, Federico

(57) **Abstract**

A memory device includes one or more memory cells, a global wordline, a plurality of local wordlines each coupled to respective memory cells of the one or more memory cells, a wordline transistor coupled to the global wordline and to a local wordline of the plurality of wordlines, and voltage generation circuitry. The voltage generation circuitry may provide a global wordline voltage to the global wordline and provide a wordline select control signal to the wordline transistor. The wordline transistor may pull a local wordline voltage of the local wordline to the global wordline voltage based on the wordline select control signal.

## Description

### BACKGROUND OF THE INVENTION

### 1. Field Of The Invention

The present invention relates generally to memory devices. More particularly, the present disclosure relates to driving storage cells of memory devices.

### 2. Description Of The Related Art

Memory devices, such as Dynamic Random-Access Memory (DRAM) devices, may include storage nodes that store data, such as a bit of binary information, as electric charge. The storage nodes may be accessed via a transistor coupled to a digitline and a wordline, each of which made of conducive material capable of carrying a charge. Further, a driver of the memory device may provide certain voltages to the digitline and wordline to read or write to or from the storage node.

Memory devices have been improving over time to have greater capacities and increased operational rates. As part of this improvement, memory components and other hardware elements may be stacked vertically or otherwise compacted to reduce an overall footprint of the memory device. Each tier of a vertically stacked memory device may include a driver that provides currents and voltages to conductive wordlines and digitlines of the tier, and the wordlines and bitlines may control access to storage elements of the memory device. However, advanced DRAM devices, such as AXRAM devices, may include drivers with larger and more numerous components to provide large ranges of currents and voltages. As such, it may be desirable to consolidate those drivers to save space within the memory device.

### BRIEF DESCRIPTION OF THE DRAWINGS

FIG. 1 is a simplified block diagram illustrating certain features of a memory device having memory cells, in accordance with an embodiment;
FIG. 2 is a schematic diagram of a memory cell of the memory device of FIG. 1 coupled to a local wordline, in accordance with an embodiment;
FIG. 3 is an illustration of the driver circuitry that may drive the local wordline of FIG. 2, including voltage generation circuitry that generates global wordline voltages and idle voltages and bank control circuitry that generates wordline select control signals and idle control signals, in accordance with an embodiment;
FIG. 4 is a schematic diagram of a portion of the driver circuitry of FIG. 3, in accordance with an embodiment;
FIG. 5 is a schematic diagram of a wordline transistor and an idle transistor of the portion of the driver circuitry of FIG. 3, in accordance with an embodiment; and
FIG. 6 is a flow chart of a method for selectively controlling one or more wordlines to access a target memory cell, in accordance with an embodiment.

### SUMMARY

The invention is as defined in independent claims; optional embodiments are defined in dependent claims,

### DETAILED DESCRIPTION OF SPECIFIC EMBODIMENTS

While the invention may be susceptible to various modifications and alternative forms, specific embodiments have been shown by way of example in the drawings and have been described in detail herein. However, it should be understood that the invention is not intended to be limited to the particular forms disclosed. Rather, the invention is to cover all modifications, equivalents, and alternatives falling within the scope of the invention as defined by the following appended claims.

As mentioned, memory devices, such as Dynamic Random-Access Memory (DRAM) devices, may include storage nodes that store data as electric charge. Each storage node may be accessed via a transistor coupled to the storage node, such as an n-channel metal-oxide semiconductor (NMOS) transistor, and the transistor may be coupled to conductive materials that carry voltage biases. In particular, a digitline coupled to a source terminal of the transistor may provide data to be stored in the storage node, and a wordline coupled to a gate terminal of the transistor may provide a control input to control access from the digitline to the storage node. As such, the transistor may act as a gate to the storage node that can be opened or closed by the wordline to control access to the storage node from a current carried by the digitline. The digitline and wordline may each be coupled to a driver component of the memory device, and the driver component may provide voltages to the digitline and wordline to allow access (e.g., read from or write to) the storage node.

Advances in DRAM devices have led to improved operational speeds and increased capacities. However, improved memory devices may have more complex structures and/or electrical characteristics. For example, three-dimensional DRAM (3DDRAM) devices, including 3D AXRAM devices, may include two or more two-dimensional DRAM components vertically stacked upon each other in tiers, which may save space in the memory device. However, 3DDRAM devices may include drivers that provide a large range of voltages to access storage elements, and components of the driver may be large and/or numerous to handle the large range of voltages. As such, including a driver at each tier of a 3DDRAM may lead to a larger size and/or lower density of storage nodes within the memory device.

Systems and methods described herein include driver circuitry that selectively controls one or more local wordlines to access a plurality of storage nodes of a memory device. Each local wordline may include a wordline transistor, and the driver circuitry may provide a global wordline voltage to a source terminal of the wordline transistor and a wordline select voltage to a gate terminal of the wordline transistor. The global wordline voltage may include data to be written to a local wordline, and the wordline select voltage may selectively enable one or more wordline transistors such that a selected local wordline is pulled to the voltage of the global word line.

The driver circuitry may provide certain voltages to the global wordline based on operating mode for accessing storage nodes along a local wordline. For example, when operating in a read mode, the driver circuitry may provide -2 (or another suitable number of) Volts to the global word line for a selected local wordline (e.g., as selected by the wordline select voltage). Through this connection gate inputs of read p-channel metal-oxide semiconductors (PMOS) of one or more storage nodes are pulled to -2 Volts thereby allowing data at the one or more storage nodes to be read. When operating in a write mode, the driver circuitry may provide 3 (or another suitable number of) Volts to the global wordline for a selected local wordline. Through this connection gate inputs of write NMOS transistors of one or more storage nodes are pulled to 3 Volts, allowing data to be written to the one or more storage nodes. Additionally, the driver circuitry may operate in an idle mode, in which -0.2 Volts is provided to the global wordline and each local wordline is deselected.

By providing global wordline voltages to multiple local wordlines, components used to drive the local wordlines, such as voltage generation circuitry, may be centralized within the memory device and/or have fewer total numbers of such circuitry in the memory device 10. The wordline transistors described herein may have an appreciably smaller size and complexity footprint than driver circuitry that may otherwise be included with every local wordline of 3DDRAM designs. As such, the systems and methods described herein may lead to a more compact memory device design. Further, the systems and methods herein may include fewer contacts (e.g., staircase contacts) at each tier than a design that includes driver circuitry at each tier.

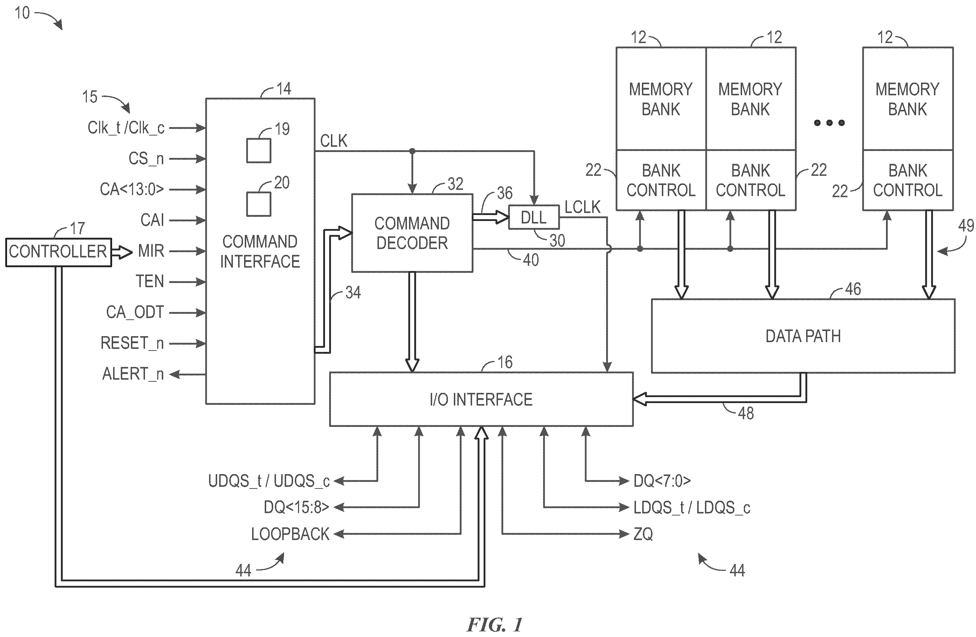

Turning now to the figures, FIG. 1 is a simplified block diagram illustrating certain features of a memory device 10. Specifically, the block diagram of FIG. 1 is a functional block diagram illustrating certain functionality of the memory device 10. In accordance with one embodiment, the memory device 10 may be a DDR5 SDRAM device. Various features of DDR5 SDRAM allow for reduced power consumption, more bandwidth and more storage capacity compared to prior generations of DDR SDRAM.

The memory device 10, may include a number of memory banks 12. The memory banks 12 may be DDR5 SDRAM memory banks, for instance. The memory banks 12 may be provided on one or more chips (e.g., SDRAM chips) that are arranged on dual inline memory modules (DIMMS). Each DIMM may include a number of SDRAM memory chips (e.g., x8 or x16 memory chips), as will be appreciated. Each SDRAM memory chip may include one or more memory banks 12. The memory device 10 represents a portion of a single memory chip (e.g., SDRAM chip) having a number of memory banks 12. For DDR5, the memory banks 12 may be further arranged to form bank groups. For instance, for an 8 gigabyte (Gb) DDR5 SDRAM, the memory chip may include 16 memory banks 12, arranged into 8 bank groups, each bank group including 2 memory banks. For a 16 Gb DDR5 SDRAM, the memory chip may include 32 memory banks 12, arranged into 8 bank groups, each bank group including 4 memory banks, for instance. Various other configurations, organizations, and sizes of the memory banks 12 on the memory device 10 may be utilized depending on the application and design of the overall system.

The memory device 10 may include a command interface 14 and an input/output (I/O) interface 16. The command interface 14 is configured to provide a number of signals (e.g., signals 15) from an external device, such as a processor or controller 17. The processor or controller 17 may provide various signals 15 (including the DQ signals) to the memory device 10 to facilitate the transmission and receipt of data to be written to or read from the memory device 10.

As will be appreciated, the command interface 14 may include a number of circuits, such as a clock input circuit 19 and a command address input circuit 20, for instance, to ensure proper handling of the signals 15. The command interface 14 may receive one or more clock signals from an external device. Generally, double data rate (DDR) memory utilizes a differential pair of system clock signals, referred to herein as the true clock signal (Clk_t) and the bar clock signal (Clk_c). The positive clock edge for DDR refers to the point where the rising true clock signal Clk_t crosses the falling bar clock signal Clk_c, while the negative clock edge indicates that transition of the falling true clock signal Clk_t and the rising of the bar clock signal Clk_c. Commands (e.g., read command, write command, etc.) are typically entered on the positive edges of the clock signal and data is transmitted or received on both the positive and negative clock edges.

The clock input circuit 19 receives the true clock signal (Clk_t) and the bar clock signal (Clk_c) and generates an internal clock signal CLK. The internal clock signal CLK is supplied to an internal clock generator, such as a delay locked loop (DLL) circuit 30. The DLL circuit 30 generates a phase controlled internal clock signal LCLK based on the received internal clock signal CLK. The phase controlled internal clock signal LCLK is supplied to the I/O interface 16, for instance, and is used as a timing signal for determining an output timing of read data.

The internal clock signal(s)/phases CLK may also be provided to various other components within the memory device 10 and may be used to generate various additional internal clock signals. For instance, the internal clock signal CLK may be provided to a command decoder 32. The command decoder 32 may receive command signals from the command bus 34 and may decode the command signals to provide various internal commands. For instance, the command decoder 32 may provide command signals to the DLL circuit 30 over the bus 36 to coordinate generation of the phase controlled internal clock signal LCLK. The phase controlled internal clock signal LCLK may be used to clock data through the IO interface 16, for instance.

Further, the command decoder 32 may decode commands, such as read commands, write commands, mode-register set commands, activate commands, etc., and provide access to a particular memory bank 12 corresponding to the command, via the bus path 40. As will be appreciated, the memory device 10 may include various other decoders, such as row decoders and column decoders, to facilitate access to the memory banks 12. In one embodiment, each memory bank 12 includes a bank control block 22 which provides the necessary decoding (e.g., row decoder and column decoder), as well as other features, such as timing control and data control, to facilitate the execution of commands to and from the memory banks 12.

The memory device 10 executes operations, such as read commands and write commands, based on the command/address signals received from an external device, such as a processor. In one embodiment, the command/address bus may be a 14-bit bus to accommodate the command/address signals (CA<13:0>). The command/address signals are clocked to the command interface 14 using the clock signals (Clk_t and Clk_c). The command interface may include a command address input circuit 20 which is configured to receive and transmit the commands to provide access to the memory banks 12, through the command decoder 32, for instance. In addition, the command interface 14 may receive a chip select signal (CS_n). The CS_n signal enables the memory device 10 to process commands on the incoming CA<13:0> bus. Access to specific banks 12 within the memory device 10 is encoded on the CA<13:0> bus with the commands.

In addition, the command interface 14 may be configured to receive a number of other command signals. For instance, a command/address on die termination (CA_ODT) signal may be provided to facilitate proper impedance matching within the memory device 10. A reset command (RESET_n) may be used to reset the command interface 14, status registers, state machines and the like, during power-up for instance. The command interface 14 may also receive a command/address invert (CAI) signal which may be provided to invert the state of command/address signals CA<13:0> on the command/address bus, for instance, depending on the command/address routing for the particular memory device 10. A mirror (MIR) signal may also be provided to facilitate a mirror function. The MIR signal may be used to multiplex signals so that they can be swapped for enabling certain routing of signals to the memory device 10, based on the configuration of multiple memory devices in a particular application. Various signals to facilitate testing of the memory device 10, such as the test enable (TEN) signal, may be provided, as well. For instance, the TEN signal may be used to place the memory device 10 into a test mode for connectivity testing.

The command interface 14 may also be used to provide an alert signal (ALERT_n) to the system processor or controller for certain errors that may be detected. For instance, an alert signal (ALERT_n) may be transmitted from the memory device 10 if a cyclic redundancy check (CRC) error is detected. Other alert signals may also be generated. Further, the bus and pin for transmitting the alert signal (ALERT_n) from the memory device 10 may be used as an input pin during certain operations, such as the connectivity test mode executed using the TEN signal, as described above.

Data may be sent to and from the memory device 10, utilizing the command and clocking signals discussed above, by transmitting and receiving data signals 44 through the IO interface 16. More specifically, the data may be sent to or retrieved from the memory banks 12 over the datapath 46, which includes multiple bi-directional data buses. Data IO signals, generally referred to as DQ signals, are generally transmitted and received in one or more bi-directional data buses. The datapath 46 may convert the DQ signals from a serial bus 48 to a parallel bus 49.

For certain memory devices, such as a DDR5 SDRAM memory device, the IO signals may be divided into upper and lower bytes. For instance, for a x16 memory device, the IO signals may be divided into upper and lower IO signals (e.g., DQ<15:8> and DQ<7:0>) corresponding to upper and lower bytes of the data signals, for instance.

To allow for higher data rates within the memory device 10, certain memory devices, such as DDR memory devices may utilize data strobe signals, generally referred to as DQS signals. The DQS signals are driven by the external processor or controller sending the data (e.g., for a write command) or by the memory device 10 (e.g., for a read command). For read commands, the DQS signals are effectively additional data output (DQ) signals with a predetermined pattern. For write commands, the DQS signals are used as clock signals to capture the corresponding input data. As with the clock signals (Clk_t and Clk_c), the DQS signals may be provided as a differential pair of data strobe signals (DQS_t and DQS_c) to provide differential pair signaling during reads and writes. For certain memory devices, such as a DDR5 SDRAM memory device, the differential pairs of DQS signals may be divided into upper and lower data strobe signals (e.g., UDQS_t and UDQS_c; LDQS_t and LDQS_c) corresponding to upper and lower bytes of data sent to and from the memory device 10, for instance.

The DQS signals are driven by the controller 17 to the memory device 10 to strobe in write data. When the write operation is complete, the controller 17 will stop driving the DQS and allow it to float to an indeterminate tri-state condition. When the DQS signal is no longer driven by the controller 17, the external DQS signal from the controller 17 to the memory device 10 will be at an unknown/indeterminate state. This state can cause undesirable behavior inside the memory device 10 because an internal DQS signal inside the memory device 10 may be at an intermediate level and/or may oscillate. In some embodiments, even the external DQS signal may ring at the I/O interface 16 when the controller 17 stops driving the external DQS signal.

The DDR5 specification may include a short postamble period where the external DQS signal is still driven by the controller 17 after the last write data bit to allow time for disabling of write circuitry to propagate before the controller 17 ceases to drive the external DQS signal. The DDR5 specification may define a short (e.g., 0.5 tCK) postamble period and a long (e.g., 1.5 tCK) postamble period that may be selected using a mode register. However, the short postamble period may provide a short period of time to reset a DFE buffer.

Returning to FIG. 1, an impedance (ZQ) calibration signal may also be provided to the memory device 10 through the IO interface 16. The ZQ calibration signal may be provided to a reference pin and used to tune output drivers and ODT values by adjusting pull-up and pull-down resistors of the memory device 10 across changes in process, voltage, and temperature (PVT) values. Because PVT characteristics may impact the ZQ resistor values, the ZQ calibration signal may be provided to the ZQ reference pin to be used to adjust the resistance to calibrate the input impedance to known values. As will be appreciated, a precision resistor is generally coupled between the ZQ pin on the memory device 10 and GND/VSS external to the memory device 10. This resistor acts as a reference for adjusting internal ODT and drive strength of the IO pins.

In addition, a loopback signal (LOOPBACK) may be provided to the memory device 10 through the IO interface 16. The loopback signal may be used during a test or debugging phase to set the memory device 10 into a mode wherein signals are looped back through the memory device 10 through the same pin. For instance, the loopback signal may be used to set the memory device 10 to test the data output of the memory device 10. Loopback may include both a data and a strobe or possibly just a data pin. This is generally intended to be used to monitor the data captured by the memory device 10 at the IO interface 16.

As will be appreciated, various other components such as power supply circuits (for receiving external VDD and VSS signals), mode registers (to define various modes of programmable operations and configurations), read/write amplifiers (to amplify signals during read/write operations), temperature sensors (for sensing temperatures of the memory device 10), etc., may also be incorporated into the memory device 10. Accordingly, it should be understood that the block diagram of FIG. 1 is only provided to highlight certain functional features of the memory device 10 to aid in the subsequent detailed description.

DDR5 allows write operations to be performed consecutively such that data entry is gapless between two consecutive writes. In this case, the normal postamble for the first write operation and/or the normal preamble for the second write operation may be completely eliminated. For some consecutive write operations, there may be cycle gaps having a certain gap (e.g., 1, 2, 3, or more cycles) between the data burst of the first write operation and the data burst of the second write operation. For these cases, there may be a specified partial postamble and/or partial preamble to support these operations.

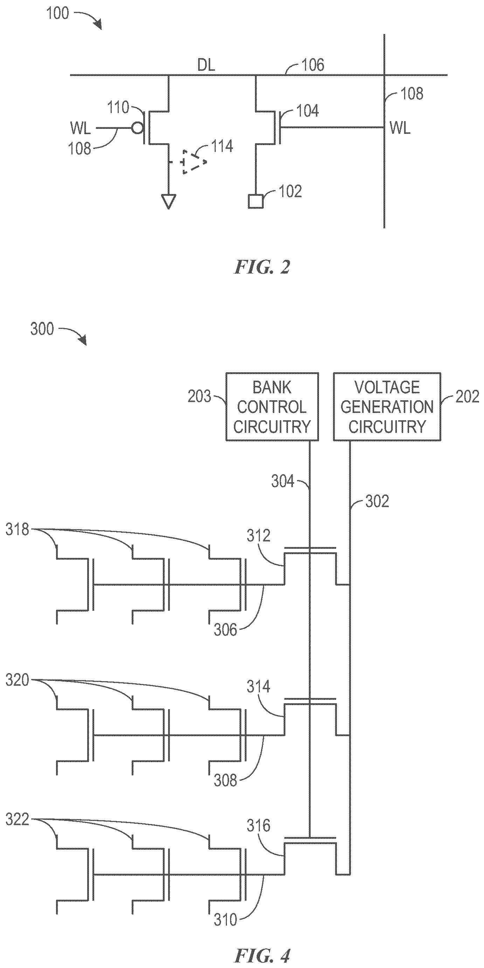

Each of the memory banks 12 may include numerous (e.g., thousands of) memory cells that store data. FIG. 2 is a schematic diagram of an example of a memory cell 100 that may be included as part of the memory banks 12. The memory cell 100 may be one of numerous memory cells arranged in an array as part of a memory bank of an AXRAM memory device, for instance. As illustrated, the memory cell 100 includes a storage node 102, which may include a capacitor capable of storing a bit of data as electric charge, coupled to a transistor, here illustrated as an NMOS transistor 104. The NMOS transistor 104 may act as a switch that controls access between a digitline 106 and the storage node 102 based on input at a gate from a wordline 108. For example, to write to the storage node 102, a high voltage value (e.g., 3 Volts) may be provided to the wordline, which may turn on the NMOS transistor 104. In response, a current may flow from the digitline 106 to the storage node 102 via the NMOS transistor 104, and the storage node 102 may store the current as electric charge.

The memory cell 100 may also include a PMOS transistor 110 coupled to the digitline 106. The PMOS transistor 110 may turn on based on a voltage value of the wordline 108 connected to a gate terminal of the PMOS transistor 110, which may allow a read of a value stored in the storage node 102. For example, to read from the storage node 102, a low voltage value (e.g., -2 Volts) may be provided to the wordline 108, which may turn on the PMOS transistor 110 and allow a sense amplifier 114 to detect a current flowing in the PMOS transistor 110 depending on charge on the storage node 102. Additionally, if an intermediate voltage value (e.g., -0.2 Volts) is provided to the wordline 108, each of the NMOS transistor 104 and the PMOS transistor 110 may remain off such that read or write access to the storage node 102 may be blocked.

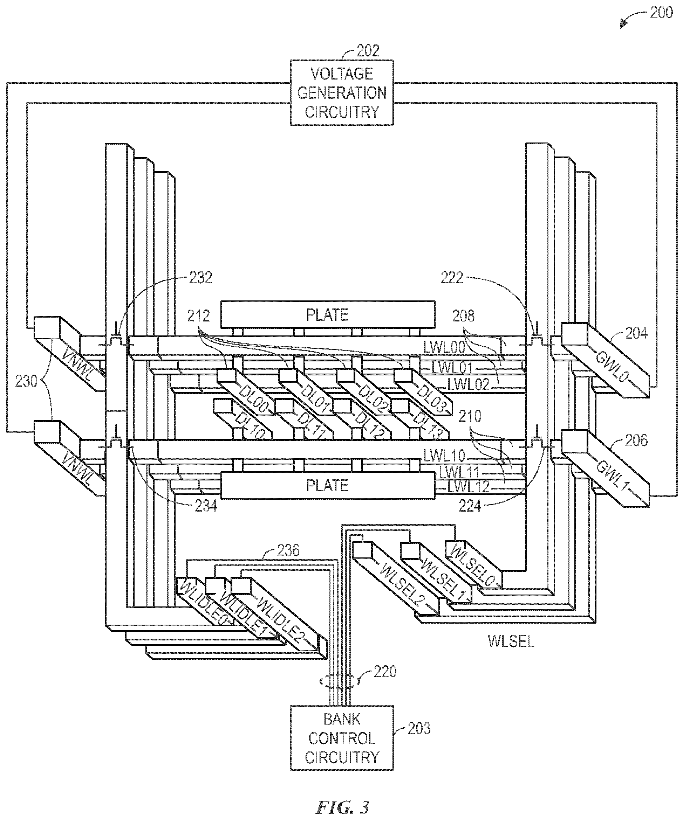

FIG. 3 is an isometric illustration of driver circuitry 200 that selectively provides voltages to local wordlines (LWL) of the memory device 10. In the illustrated embodiment, the driver circuitry 200 includes voltage generation circuitry 202 that provides global wordline voltages to global wordlines 204 and 206. Each of the global wordlines 204 and 206 may provide a global wordline voltage generated by the voltage generation circuitry 202 to a respective region of a memory device, and each respective region may include one or more local wordlines 208 or 210. Further, each of the one or more local wordlines 208 and 210 may provide a local wordline voltage to multiple memory cells to control access between one or more digitlines 212 and the multiple memory cells. In other words, a global wordline (GWL) may correspond to a region of the memory device, and each local wordline may control access to a row of memory cells within the region.

The driver circuitry 200 also includes bank control circuitry 203 that may selectively couple the global wordline 204 to the local wordlines 208 and the global wordline 206 to the local wordlines 210 by providing wordline select control signals to select lines 220. Each of the local wordlines 208 may include a respective local wordline transistor 222, and each local wordline transistors may include a gate input coupled to one of the select lines 220. Based on a wordline select control signal of a select line coupled to the respective local wordline transistor 222, the respective local wordline transistor 222 may pull a voltage of the local wordlines 208 to a voltage value of the global wordline 204. Likewise, based on a wordline select control signal of a select line coupled to the local wordline transistor 224, the local wordline transistor 224 may pull a voltage of the local wordlines 210 to a voltage value of the global wordline 206.

The voltage generation circuitry 202 may also provide an idle voltage to idle lines 230. Like the global wordlines 204 and 206, each of the idle lines 230 may provide the idle voltage to a respective region of a memory device, and each respective region may include the local wordlines 208 or 210. The bank control circuitry 203 may also provide idle select control signals to gate inputs of idle transistors 232 and 234 via idle select lines 236 to selectively decouple the idle lines 230 from corresponding local wordlines 208 and 210. The idle lines 230, when coupled to the local wordlines 208 or 210 via the idle transistors 232 or 234, may provide an idle voltage to the local wordlines 208 or 210.

FIG. 4 is a schematic diagram of a portion 300 of the driver circuitry 200 that may selectively provide voltages to local wordlines of a region of a memory device. The portion 300 represent, for example, a global wordline, local wordlines, and local wordline transistors of a region of a memory device that includes the driver circuitry 200. For example, a global wordline 302 may represent the global wordline 204 of FIG. 3, the select line 304 may represent one of the select lines 220 of FIG. 3, the local wordlines 306, 308, and 310 may represent the one or more local wordlines 208, the local wordline transistors 312, 314, and 316 may represent the respective local wordline transistors 222, and so on. The portion 300 may also represent other global wordlines, other local wordlines, other local wordline transistors, and the like (e.g., of a different region).

Further, while the portion 300 is described as selectively providing voltages to local wordlines of a region of a memory device, the portion 300 may also represent a portion of the driver circuitry 200 that may selectively provide idle voltages to local wordlines. For example, the global wordline 302 may represent an idle line of the idle lines 230, the local wordline transistors 312, 314, and 316 may represent the idle transistors 232 or 234, and so on. It should be noted, however, that while the idle voltage may remain at a constant idle voltage value (e.g., - 0.2 Volts) to maintain an idle state of one or more memory cells, the voltage value of the global wordline may be provided by the voltage generation circuitry 202 at varying values according to, for example, a read or write mode of one or more memory cells.

In the illustrated embodiment, the voltage generation circuitry 202 may provide a high voltage value (e.g., 3 Volts) to the global wordline 302 to write to one or more memory cells of a region or may provide a low voltage value (e.g., -2 Volts) to the global wordline 302 to read to one or more memory cells of a region. To selectively couple the global wordline 302 to the local wordline 306, 308, and/or 308, bank control circuitry may provide a wordline select control signal to the select line 304. As such, a local wordline voltage of the local wordlines 306, 308, and 310 may depend on a wordline select control signal of the select line 304 and a global wordline voltage of the global wordline 302, as will be described in more detail below. Further, each of local wordlines 306, 308, and 310 may be coupled to gate inputs of memory cell transistors 318, 320, and 322, respectively. The memory cell transistors 318, 320, and 322 may represent, for example, the NMOS transistor 104 and/or the PMOS transistor 110 of FIG. 2. As described with reference to FIG. 2, the voltage at the gate inputs of the NMOS transistor 104 and/or the PMOS transistor 110 may allow a read or write to a storage node of a memory cell.

In one embodiment, the select line 304 provides the wordline select control signal as a gate input to each of the local wordline transistors 312, 314, and 316 that activates all memory cells in at least a portion of a row of memory cells at one time. In another embodiment, the bank control circuitry may provide separate wordline select control signals to each of local wordline transistors 312, 314, and 316 via different select lines, which may allow selective reads and writes to memory cells that include the memory cell transistors 318, 320, and 322. For example, a first wordline select control signal may be provided to a gate input of the wordline transistor 312, and a second wordline select control signal may be provided to a gate input of the wordline transistor 314. As such, voltage values of the local wordline 306 and the local wordline 308 may differ. This may allow the memory cell transistors 318 to turn on and allow memory cell transistors 320 to turn off, for instance.

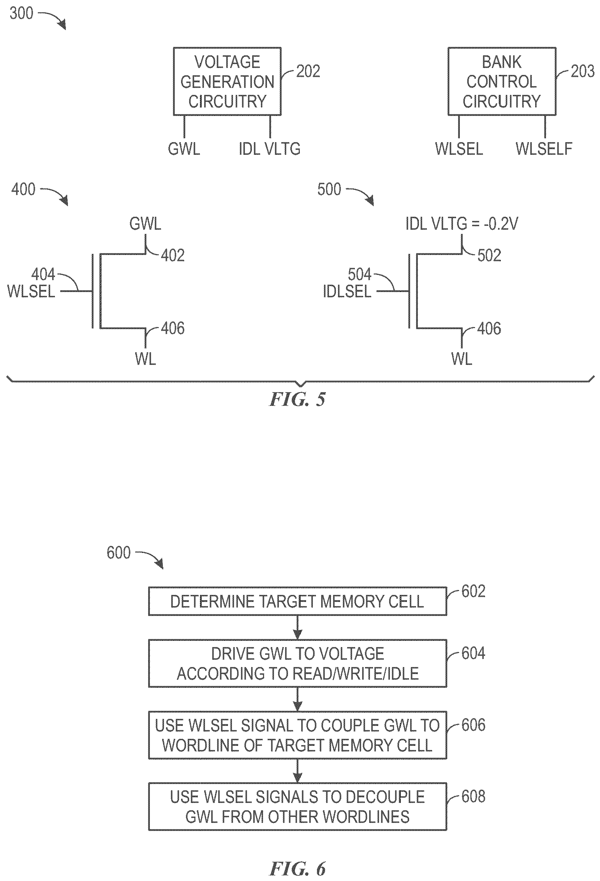

To illustrate operation of the local wordline transistors 312, 314, and 316 of FIG. 4, FIG. 5 illustrates a schematic diagram of a wordline transistor 400, including a global wordline voltage (GWL) 402, a wordline select control signal (WLSEL) 404, and a wordline voltage (WL) 402. In addition, FIG. 5 includes an illustration of an idle transistor 500, with an idle voltage 502, an idle select control signal (IDLSEL) 504, and the wordline voltage 406. As may be appreciated, the drain terminal of both the wordline transistor 400 and the idle transistor 500 may be coupled to a local wordline, such as the local wordline 306 of FIG. 4, for example, and the local wordline may be coupled to a gate input of one or more transistors of a memory cell, such as the memory cell 100 of FIG. 2. Further, in the illustrated example, the idle voltage 502 may be driven to -0.2 Volts (e.g., as a constant idle voltage). Thus, charge for the wordline voltage 402 may be injected via using the WLSEL 404 and discharged using the IDLSEL 504.

To read from one or more memory cells, the wordline voltage 402 may be pulled to a low voltage, such as -2 Volts. Pulling the wordline voltage 402 to the low voltage may allow a PMOS transistor having a gate input of the wordline voltage 402 to turn on, which may allow a sense amplifier to read a value of the storage node, as described above. To pull the wordline voltage 402 to the low voltage (e.g., to enter a read mode), the bank control circuitry 203 may drive the WLSEL 404 to a low voltage, such as 1 Volt. In addition, the voltage generation circuitry 202 may provide a low voltage, such as -2 Volts, as the global wordline voltage 402. The voltage generation circuitry may also provide the idle voltage 502 as -0.2 Volts, and the bank control circuitry 203 may drive the IDLSEL 504 to a low voltage, such as -2 Volts. Based on the GWL 402, WLSEL 404, the idle voltage 502, IDLSEL 504, as well as threshold voltages of the wordline transistor 400 and the idle transistor 500, the wordline voltage 406 may be pulled to the desired low voltage of -2 Volts.

To write to one or more memory cells, the wordline voltage 402 may be pulled to a high voltage, such as 3 Volts. Pulling the wordline voltage 402 to the high voltage may allow an NMOS transistor having a gate input of the wordline voltage 402 to turn on, which may allow current carried by a digitline to flow to a storage node, where it may be stored as electric charge, as described above. To pull the wordline voltage to the high voltage (e.g., to enter a write mode), the voltage generation circuitry 202 may provide a high voltage, such as 4 Volts, as the WLSEL 404. Additionally, the voltage generation circuitry 202 may drive the global wordline voltage to a high voltage, such as 3 Volts. The voltage generation circuitry 202 may continue to provide an intermediate voltage, such as -0.2 Volts, as the idle voltage 502, and the bank control circuitry may drive the IDLSEL 504 to a low voltage, such as -2 Volts. Based on the GWL 402, WLSEL 402, the idle voltage 502, IDLSEL 504, as well as threshold voltages of the wordline transistor 400 and the idle transistor 500, the wordline voltage 406 may be pulled to the desired high voltage of 3 Volts.

The wordline voltage 406 may also be pulled to an idle voltage, which may be an intermediate voltage between the low voltage (e.g., for a read operation) and the high voltage (e.g., for a write operation), such as -0.2 Volts. The idle voltage, when applied to transistors of one or more memory cells, may turn off and/or not turn the transistors of the memory cells, such that storage nodes are not written to or read from. To pull the wordline voltage 406 to the idle voltage (e.g., to enter an idle mode), the bank control circuitry 203 may provide a low voltage, such as -2 Volts, as the WLSEL 404. Further, the voltage generation circuitry 202 may pull the global wordline voltage 402 to an intermediate voltage, such as -0.2 Volts. The voltage generation circuitry 202 may also provide the intermediate voltage (e.g., -0.2 Volts) as the idle voltage 502, and the bank control circuitry 203 may provide a high voltage, such as 1 Volt, as the IDLSEL 504. Based on the GWL 402, WLSEL 402, the idle voltage 502, IDLSEL 504, as well as threshold voltages of the wordline transistor 400 and the idle transistor 500, the wordline voltage 406 may be pulled to the desired idle voltage of -0.2 Volts.

In the illustrated embodiment, if none of the above read mode, write mode, or idle mode are entered based on the voltages provided by the voltage generation circuitry 202, the wordline voltage 406 may be pulled to the idle voltage (e.g., -0.2 Volts). That is, the wordline voltage 406 may default to the idle voltage in the absence of a read, write, or idle operation. For example, if the voltage generation circuitry 202 pulls the global wordline voltage 402 to a low voltage of -2 Volts (e.g., as in a read operation), but the WLSEL 404 is provided as a low voltage (e.g., is deselected), the wordline voltage 406 may be pulled to the idle voltage. Similarly, if the voltage generation circuitry 202 pulls the global wordline voltage 402 to a high voltage of 3 Volts (e.g., as in a write operation), but the WLSEL 404 is provided as a low voltage, the wordline voltage 406 may be pulled to the idle voltage. As such, a low voltage being provided as the WLSEL 404 may correspond to the wordline transistor being deselected, and may not cause a wordline voltage 406 that would cause any read or write action for memory cells coupled to the wordline voltage 406.

FIG. 6 is a flow chart of a method 600 for selectively controlling one or more wordlines (e.g., the wordline 108 of FIG. 2) to access a plurality of storage nodes (e.g., the storage node 102) of a memory device that may be performed by the portion 300 of the driver circuitry 200. Further, the method 600 may be described for one global wordline (e.g., for one region of a memory device) but may be performed in parallel for multiple global wordlines (e.g., for multiple regions of a memory device). In block 602, the method 600 may begin with determining a target memory cell. The target memory cell may include a memory cell of a memory device, such as the memory cell 100 of FIG. 2 for which driver circuitry 200 enter a read mode, write mode, or idle mode, as described herein. In some embodiments, block 602 may include determining multiple target memory cells. For example, a read mode, write mode, or idle mode may be entered for one or more memory cells having a transistor arranged on a common local wordline, such as memory cells of the memory cell transistors 318 along the local wordline 206 of FIG. 4. Moreover, a mode (e.g., write or read) for one memory cell may impliedly set a mode (e.g., idle) for one or more other memory cells.

In block 604, the voltage generation circuitry 202 may drive the GWL 402 to a voltage based on a read operation, write operation, or idle operation of the target memory cell. As described herein, for a read operation, the voltage generation circuitry 202 may provide a low voltage, such as -2 Volts, as the GWL 402. For a write operation, voltage generation circuitry 202 may drive the GWL 402 to a high voltage, such as 3 Volts. Finally, to enter an idle operation of the target memory cell, the voltage generation circuitry 202 may provide an intermediate voltage, such as -0.2 Volts, as the GWL 402.

In block 606, the portion 300 of the driver circuitry 200 may use the WLSEL 404 to couple the GWL 402 to a local wordline of the target memory cell. For example, for a read operation, the bank control circuitry 203 may drive the WLSEL 404 to a low voltage, such as 1 Volt. For a write operation of the target memory cell, the bank control circuitry 203 may drive the WLSEL 404 to a high voltage, such as 4 Volts. For an idle operation, the bank control circuitry 203 may pull the WLSEL 404 to a lower voltage, such as -2 Volts.

In block 608, the portion 200 may use the WLSEL 404 to decouple the GWL 402 from other local wordlines. This may deselect the other local wordlines, and may cause transistors of memory cells on the other wordlines to enter or maintain an idle mode. For example, the bank control circuitry 203 may drive the WLSEL to -2 Volts for the other wordlines, which may decouple the other local wordlines from the GWL 402.

## Claims

1. A memory device, comprising:
one or more memory cells;
a global wordline;
a plurality of local wordlines each coupled to respective memory cells of the one or more memory cells;
a wordline transistor coupled to the global wordline and to a local wordline of the plurality of wordlines;
voltage generation circuitry configured to:
provide a global wordline voltage to the global wordline;
provide a wordline select control signal to the wordline transistor, wherein the wordline transistor is configured to pull a local wordline voltage of the local wordline to the global wordline voltage based on the wordline select control signal.

2. The memory device of claim 1, comprising an idle transistor coupled to an idle line and to the local wordline, and wherein the voltage generation circuitry is configured to provide:
an idle voltage to the idle line; and
an idle select control signal to the idle transistor, wherein the wordline transistor and the idle transistor are configured to pull the local wordline voltage of the local wordline to the global wordline voltage or the idle voltage based on the wordline select control signal and the idle select control signal.

3. The memory device of claim 1, wherein each of the one or more memory cells comprises a transistor coupled to a storage node.

4. The memory device of claim 3, wherein the global wordline voltage comprises a first value corresponding to a read operation of the one or more memory cells, a second value corresponding to a write operation of the one or more memory cells, or a third value corresponding to an idle operation of the one or more memory cells.

5. The memory device of claim 4, wherein the first value and the second value are greater than 3 Volts apart.

6. The memory device of claim 5, wherein the third value is between the first value and second value.

7. The memory device of claim 4, wherein the local wordline of the plurality of wordlines is coupled to the one or more memory cells via gate terminals of respective transistors of each of the one or more memory cells.

8. The memory device of claim 1, comprising:
an additional global wordline;
a plurality of additional local wordlines each coupled to additional respective memory cells of the one or more memory cells;
an additional wordline transistor coupled to the additional global wordline and to an additional local wordline of the plurality of additional local wordlines, wherein the voltage generation circuitry is configured to:
provide an additional global wordline voltage to the additional global wordline; and
provide the wordline select control signal to the additional wordline transistor,
wherein the additional wordline transistor is configured to pull an additional local wordline voltage of the additional local wordline to the additional global wordline voltage based on the wordline select control signal.

9. The memory device of claim 1, wherein the one or more memory cells and the one or more additional memory cells are disposed in different regions of the memory device.

10. A method, comprising:
providing, when operating in a read mode of one or more memory cells:
a first global wordline voltage to a global wordline of a memory device;
a first wordline select control signal to a wordline transistor coupling a local wordline and the global wordline; and
a first idle select control signal to an idle transistor coupling the local wordline and an idle line; and
providing, when operating in a write mode of the one or more memory cells:
a second global wordline voltage to the global wordline of the memory device;
a second wordline select control signal to the wordline transistor coupling the local wordline and the global wordline; and
the first idle select control signal to the idle transistor coupling the local wordline and the idle line.

11. The method of claim 10, wherein the first wordline select control signal and the second wordline select control signal have the same voltage when asserted.

12. The method of claim 10, wherein the first global wordline voltage is less than the second global wordline voltage.

13. The method of claim 12, wherein the first wordline select control signal comprises a first voltage less than a second voltage the second wordline select control signal.

14. The method of claim 10, comprising:
providing, when operating in an idle mode of the one or more memory cells,
a third global wordline voltage to the global wordline of the memory device
a third wordline select control signal to the wordline transistor coupling the local wordline and the global wordline; and
a second idle select control signal to the idle transistor coupling the local wordline and the idle line.

15. The method of claim 14, wherein the third global wordline voltage is between the first global wordline voltage and the second global wordline voltage, the third wordline select control signal comprises a first voltage less than a second voltage of the first wordline select control signal and a third voltage of the second wordline select voltage, and the second idle select control signal comprises a fourth voltage less than a fifth voltage of the first idle select control signal.
